# EUROPEAN PATENT APPLICATION

(11) **EP 1 482 515 A2**
(43) Date of publication of application: **01.12.2004**
(21) Application number: 04011926.5
(22) Date of filing: 19.05.2004
(51) Int. Cl.: G11C 13/04, G11B 7/0065

(54) **Holographic data storage medium**

(30) Priority: 31.05.2003 KR 2003035040
(71) Applicant: Daewoo Electronics Corporation, Seoul (KR)
(72) Inventor: Park, Joo-Youn Daewoo Electronics Corp., Mapo-gu Seoul (KR)
(74) Representative: Jacoby, Georg, Dr.

(57) **Abstract**

A holographic data storage medium of the present invention includes a recording material layer (202) for storing a hologram and a laser absorptive layer (208) for absorbing a laser beam which passes through the recording material layer (202). The laser absorptive layer (208) is formed above the recording material layer (202).

## Description

The present invention relates to a holographic data storage medium; and, more particularly, to a holographic data storage medium which is capable of improving user's safety by adding a laser absorptive layer for absorbing a laser beam.

Currently, various kinds of holographic data storage media have been developed. Among them, some kinds of the holographic data storage media, e.g., a holographic WORM (write once read many) disk and a holographic rewritable disk, are used being contained in a disk cartridge not to be exposed to light since they may lose data stored therein in case of being exposed to light.

On the other hand, other kinds of the holographic data storage media, e.g., a holographic ROM (read-only memory) disk, are not required to be contained in such a cartridge since a replication process on the holographic ROM is followed by a post-treatment process for exhausting a photosensitivity of a recording material of the holographic ROM disk with ultraviolet or visible rays so that data stored therein is not lost even when they are exposed to light.

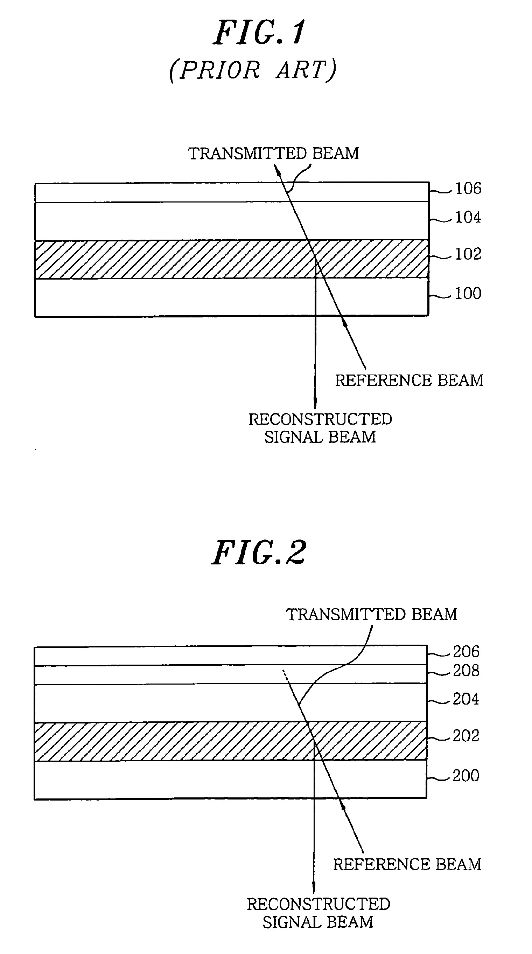

Referring to Fig. 1, there is shown a cross sectional view of a conventional holographic ROM disk. The holographic ROM disk includes a lower substrate layer 100, a holographic recording material layer 102 formed on an upper surface of the lower substrate layer 100, an upper substrate layer 104 formed on an upper surface of the holographic recording material 102 and a label layer 106 which serves as a label and is formed on an upper surface of the upper substrate layer 104. The lower and the upper substrate layer 100 and 104 for protecting the holographic recording material layer 102 are formed of, e.g., a transparent polycarbonate. The holographic recording material layer 102, formed of a holographic material, for example, photopolymer, stores data in a form of hologram.

Data stored in such a conventional holographic ROM disk in the form of hologram is reconstructed by using a laser beam (hereinafter, referred to as a reference beam). That is, if the reference beam is incident upon the holographic ROM disk, a part of the reference beam is diffracted by the hologram (a holographic interference pattern) of the holographic ROM disk to make a reconstructed signal beam (see Fig. 1). This reconstructed signal beam is converted to an electrical signal by a pick-up module (not shown) of a holographic ROM system, and then the electrical signal experiences a step of processing the data. At this time, the remaining part of the reference beam, which is not diffracted by the hologram, becomes a transmitted beam transmitted through the recording material layer 102 (see Fig. 1). Since the label layer 106 does not absorb the transmitted beam, the transmitted beam sequentially passes through the upper substrate layer 104 and the label layer 106 to be emitted to the outside of the holographic ROM disk. Further, since a diffraction efficiency (a ratio of an intensity of the signal beam to an intensity of the reference beam) in such holographic ROM disk is generally equal to or less than 20%, the intensity of the transmitted beam is equal to or greater than 80%.

As described above, since the high intensity transmitted beam is emitted from the holographic ROM disk upwardly, the transmitted beam may be escaped to the outside of the holographic ROM system. Further, in case the holographic ROM system is operated with its outer casing removed for its repair, the transmitted beam can be directly incident upon a human body. Particularly, if the transmitted beam is incident upon an eye, the eye may be in a great danger.

It is, therefore, an object of the present invention to provide a holographic data storage medium which is capable of improving user's safety by preventing a transmitted beam from being emitted to the outside thereof.

In accordance with one aspect of the invention, there is provided a holographic data storage medium, including: a recording material layer for storing a hologram and a laser absorptive layer for absorbing a laser beam which passes through the recording material layer. The laser absorptive layer is formed above the recording material layer.

The above and other objects and features of the present invention will become apparent from the following description of the preferred embodiments given in conjunction with the accompanying drawings, in which:
Fig. 1 illustrates a cross sectional view of a conventional holographic ROM disk;
Fig. 2 shows a cross sectional view of a holographic ROM disk in accordance with the first preferred embodiment of the present invention; and
Fig. 3 depicts a cross sectional view of a holographic ROM disk in accordance with the second preferred embodiment of the present invention.

Preferred embodiments of the present invention will now be described in detail with reference to the accompanying drawings, wherein like parts appearing in Figs. 2 to 3 are represented by like reference numerals.

Referring Fig. 2, there is illustrated a cross sectional view of a holographic ROM disk in accordance with the first preferred embodiment of the present invention. As shown in Fig. 2, the holographic ROM disk includes a lower and an upper substrate layer 200 and 204 made of, e.g., transparent polycarbonate; a holographic recording material layer 202 for storing data in a form of hologram (holographic interference pattern), which is disposed between the lower and the upper substrate layer 200 and 204; a laser absorptive layer 208 for absorbing a transmitted beam passing through the recording material layer 202, which is formed on an upper surface of the upper substrate layer 204; and a label layer 206 for entering a disk's title and the like, which is formed on an upper surface of the laser absorptive layer 208.

With this structure, the transmitted beam is passing through the upper substrate layer 204 and then absorbed by the laser absorptive layer 208 which is made of a laser absorptive material, such as an inconel material including Ni, Cr, Co and Fe. The laser absorptive layer 208 has an appropriate thickness. Therefore, the holographic ROM disk of the present preferred embodiment can prevent the transmitted beam from being emitted to the outside thereof.

In order to reconstruct the data stored in a form of hologram in the holographic ROM disk of the first preferred embodiment, a laser beam (hereinafter referred to as a reference beam) is incident upon the holographic ROM disk. Then, a part of the reference beam is diffracted by the hologram in the recording material layer 202 to make a reconstructed signal beam, and the remaining part of the reference beam passes through the recording material layer 202 to make the transmitted beam. The reconstructed signal beam is converted to an electrical signal by a holographic pick-up module (not shown) of a holographic ROM system. The transmitted beam, which is transmitted through the recording material layer 202, is transmitted through the upper substrate layer 204 and then reaches the laser absorptive layer 208. The laser absorptive layer 208, which is made of a laser absorptive material such as the inconel material including Ni, Cr, Co and Fe and has an appropriate thickness, absorbs the transmitted beam incident thereupon. Therefore, since the transmitted beam, i.e., the reference beam which is not diffracted by the hologram in the recording material layer and passes through the recording material layer, is prevented from being emitted to the outside of the holographic ROM disk of the present invention during the data retrieving operation, user's safety can be effectively improved.

In this preferred embodiment, the laser absorptive layer is formed between the upper substrate layer 204 and the label layer 206, but it can be formed between the recording material layer 202 and the upper substrate layer 208.

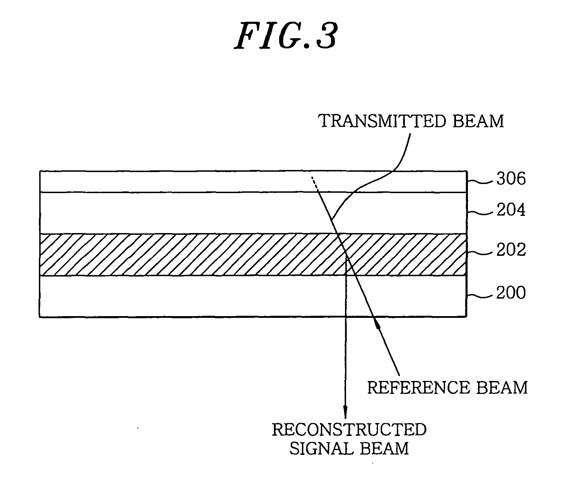

Referring Fig. 3, there is described a cross sectional view of a holographic ROM disk in accordance with the second preferred embodiment of the present invention, wherein parts like to those of the first preferred embodiment are represented by like reference characters and detailed description therefor will be omitted for simplicity.

As shown in Fig. 3, the holographic ROM disk of the second preferred embodiment is identical to that of the first preferred embodiment except that a laser absorptive layer also serves as a label layer. That is, on an upper surface of the upper substrate layer 204, a laser absorptive label layer 306, which is made of a material including a laser absorptive material such as an inconel material including Ni, Cr, Co and Fe and has an appropriate thickness, is provided.

The laser absorptive label layer 306 absorbs the transmitted beam incident thereupon. In addition, the laser absorptive label layer 306 is used as the label layer for entering a disk's title and the like. Therefore, the transmitted beam is prevented from being emitted to the outside of the holographic ROM disk. Besides, since the label layer and the laser absorptive layer are formed simultaneously, manufacturing processes of holographic ROM disk can be reduced.

In order to reconstruct the data stored in a form of hologram in the holographic ROM disk of this preferred embodiment, a laser beam (hereinafter, referred to as a reference beam) is incident thereupon. A part of the reference beam is diffracted by the hologram in the recording material layer 202 to make the reconstructed signal beam, and the remaining part of the reference beam is transmitted through the recording material layer 202 to make the transmitted beam. The reconstructed signal beam is converted to an electrical signal by a holographic pick-up module (not shown) of the holographic ROM system. The transmitted beam, which is transmitted through the recording material layer 202, is transmitted through the upper substrate layer 204 and then reaches the laser absorptive label layer 306. The laser absorptive label layer 306 absorbs the transmitted beam incident thereupon. Therefore, since the transmitted beam, i.e., a part of the reference beam which is not diffracted by the hologram in the recording material layer 202 and passes through the recording material layer 202, is prevented from being emitted to the outside of the holographic ROM disk of the present invention during the data retrieving operation, user's safety can be improved.

As described above, the holographic ROM disk in accordance with the present invention is capable of improving user's safety by preventing the transmitted beam from being emitted to the outside thereof.

Further, the present invention is described with the holographic ROM disk, but it is apparent that the present invention can be applied to any disks having a recording material which allows at least a part of a reference beam used for reconstructing data to pass therethrough.

While the invention has been shown and described with respect to the preferred embodiments, it will be understood by those skilled in the art that various changes and modifications may be made without departing from the scope of the invention as defined in the following claims.

## Claims

1. A holographic data storage medium, comprising:
a recording material layer for storing hologram; and
a laser absorptive layer for absorbing a laser beam which passes through the holographic recording material layer.

2. The holographic data storage medium of claim 1, wherein the laser absorptive layer is formed above the recording material layer.

3. The holographic data storage medium of claim 2, further comprising:
a lower substrate layer for protecting the recording material layer, which is formed on a lower surface of the recording material layer; and
an upper substrate layer for protecting the recording material layer, which is formed on an upper surface of the recording material layer,
wherein the laser absorptive layer is formed on an upper surface of the upper substrate layer.

4. The holographic data storage medium of claim 3, further comprising a label layer which serves as a label and is formed on an upper surface of the laser absorptive layer.

5. The holographic data storage medium of claim 3, wherein the laser absorptive layer serves as a label.
